# EUROPEAN PATENT APPLICATION

(11) **EP 4 582 872 A1**
(43) Date of publication of application: **09.07.2025**
(21) Application number: 23858568.1
(22) Date of filing: 01.03.2023
(51) Int. Cl.: G03F 7/027, G03F 7/004

(54) **PHOTORESIST-FREE OPTICAL PATTERNING METHOD FOR COLLOIDAL NANOCRYSTALS IN GREEN SOLVENT**

(30) Priority: 31.08.2022 CN 202211052499
(71) Applicant: Nanjing University, Nanjing, Jiangsu 210023 (CN)
(72) Inventor: WANG, Yuanyuan, Nanjing, Jiangsu 210023 (CN); XIAO, Pengwei, Nanjing, Jiangsu 210023 (CN); ZHANG, Zhoufan, Nanjing, Jiangsu 210023 (CN); LUO, Huanhuan, Nanjing, Jiangsu 210023 (CN)
(74) Representative: Cabinet Chaillot
(86) International application number: PCT/CN2023/078990
(87) International publication number: WO 2024/045525

(57) **Abstract**

The present invention relates to the technical field of nanomaterials and optical etching, and provides a photoresist-free optical patterning method for colloidal nanocrystals in a green solvent. A photosensitive ligand structurally similar to the green solvent is introduced to successfully disperse nanocrystals in the green solvent and perform photolithography directly on the nanocrystals. Photosensitive nanocrystals obtained through ligand exchange can be effectively dispersed in the green solvent to absorb an emission spectrum emitted by the green solvent, thereby preserving about 90% of photoluminescence quantum yield (PLQY) while keeping the morphology and size unchanged. The scheme solves the problem that nanocrystals cannot be subject to direct photolithography in the green solvent, and is expected to be applied to the commercialization of nanocrystals in the field of electroluminescent and photoluminescent quantum dot displays.

## Description

### 1. Technical Field

The invention belongs to the technical field of nanomaterials and optical etching, specifically relates to a photoresist-free optical patterning method for colloidal nanocrystals in a green solvent.

### 2. Background Art

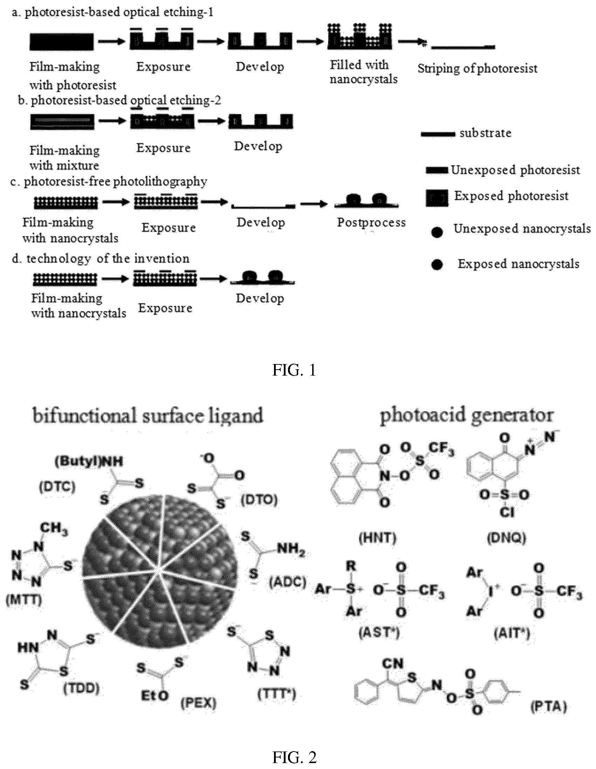

Currently, optical patterning of nanocrystals (NCs) is based on two approaches: (1) photoresist-based photophotolithography technique. This method mainly utilizes commercial photoresist, which are more mature, and can be subdivided into two different ways: (i) direct photolithography of commercial photoresist and partial stripping of the photoresist with developing solution, followed by filling the nanocrystals into photoresist templates, and then stripping the photoresist to obtain the patterned nanocrystals (FIG. 1a). (ii) Direct mixing of nanocrystals with commercial photoresist, followed by direct photolithography of the mixture, embedding the nanocrystals into the photoresist and stripping some of the photoresist and nanocrystals in the developing solution (FIG. 1b). (2) Photoresist-free direct photolithography technique. A photoacid generator (PAG) or a bifunctional surface ligand is introduced into the colloidal nanocrystal system (FIG. 2). At specific wavelengths, the introduced photoactive substance decompose, causing a change in the surface environment of the nanocrystals, which affects their stability in some solvents, and the nanocrystals are rinsed with the corresponding solvents to remove the unexposed portion (FIG. 1c). Such ligands have a wide range of sensitivities, from deep ultraviolet (DUV, 254 nm) to visible light (450 nm), and can be used to lithograph nanocrystals containing specific photosensitive groups.

Nanocrystal patterning with the help of photoresist cannot avoid the introduction of photoresist, but the commercial photoresist cannot effectively remove the photoresist during the development process, and the remaining residual photoresist will have a great impact on the charge transfer, heat transfer and other properties of the nanocrystals, and the cost of photoresist itself is relatively high, which will increase the cost of the nanocrystal patterning process.

Although the problems associated with the introduction of commercial photoresist can be avoided, the nanocrystals cannot be directly dispersed in green solvents such as propylene glycol methyl ether acetate (PGMEA), diethylene glycol monoethyl ether acetate (DGMEA), and octane, and the patterning process can only be performed in industrially unacceptable solvents such as toluene, and N,N-dimethylformamide (DMF), which greatly restricts the application of the nanocrystal patterning process in actual industrial production. In addition, the introduction of functional ligands will change the composition of the nanocrystal surface and cause damage to the nanocrystal surface, which further affects the optical properties of the nanocrystals, and therefore the nanocrystals need to be postprocessed to repair the nanocrystals' surface after the patterning process is completed to restore some of the properties.

### 3. Summary of the Invention

The invention solves the above technical problems in the prior art by proposing a Photo Induced Crosslink Lithography (PICL) and designing a bifunctional ligand. On the one hand, these ligands are partially structurally similar to green solvents, and can assist the nanocrystals to be dispersed in green solvents such as PGMEA, DGMEA, octane, and so on, according to the principle of "like dissolves like", after being attached to the nanocrystals' surfaces with carboxylate radical or amino or sulfhydryl group; on the other hand, these ligands have photosensitive methacryloyl or benzophenone groups, and are suitable for the photo-induced crosslinking of nanocrystals. On the other hand, these ligands have a photosensitive methylacryloyl group or benzophenone group, which can carry out coupling polymerization under specific wavelengths of light to realize direct lithographic patterning of the nanocrystals due to the photosensitive nature of the group. This method retains the advantage of easy operation of photoresist-free photolithography technique without damaging surface of nanocrystals, and can preserve fluorescent properties of the nanocrystals and shorten the distance between the nanocrystals while completing the patterning, thus effectively improving the efficiency of charge transfer between the nanocrystals.

The technical solution of the present invention is as follows:
A green photosensitive nanocrystal coating comprises nanocrystals and photosensitive ligands; all the selected photosensitive ligands contain carboxylate radical or amino or mercapto group that coordinates with the nanocrystals, and methylacryloyl or benzophenone photosensitive group.

Preferably, the photosensitizing ligand is any one of 2-(3-mercaptopropionyloxy)ethyl methacrylate, 5-[3-methoxy-4-(2-(2-methylprop-2-enoyloxy)phenyl]valeral-4-olefine acid, (2E)-3-(3-methoxy-4-{2-[(2-methylprop-2-enoyl)oxygroup]ethoxy}phenyl)prop-2-olefine acid, 4-(4-(methacryloyloxy)phenoxy)-4-oxobutanoic acid, mono-2-(methacryloyloxy) ethylsuccinate, (E)-6-(4-(methacryloyloxy)phenyl)-4-oxohex-5-olefine acid, (E)-6-(4-(methacryloyloxy)-3-methoxyphenyl)-4-oxohex-5-olefine acid, (E)-6-(4-(methacryloyloxy)-3, 5-dimethoxyphenyl)-4-oxohex-5-olefine acid, 2-(6-(2-(methacryloyloxy) ethoxy)-2-oxo-2H-chromen-3-yl) acetic acid, phenyl-[4-(10-mercaptodecyloxy)phenyl]methanone, phenyl-[4-(10-mercaptodecylthio)phenyl]methanone, and 4-pyrrolidinyl-phenyl-[4-(10-mercaptodecylthio)phenyl]methanone.

Preferably, the nanocrystals comprise a primary organic ligand, and the primary organic ligand is any one or a combination of carboxylic acids, phosphonic acids, amines with an aliphatic chain of more than 8 carbons. More preferably, the primary organic ligand is a combination of any one or more of oleic acid, stearic acid, palmitic acid, oleylamine, octadecylamine, octadecylphosphonic acid.

Preferably, the nanocrystals comprise CdS, CdSe, CdSe/ZnS, CdSeS/ZnS, CdSe/CdZnSeS/ZnS, CdZnS/ZnS, CdZnSe/ZnS, ZnSe/ZnS, CdSe/CdS, CdSeS/CdS, InP , InP/ZnS, InP/ZnSe/ZnS, InGaP/ZnSe/ZnS, CdTe, PbS, PbSe, PbS/CdS, Fe₂O₃, Fe₃O₄, TiO₂, ITO, In₂O₃, CsPbBr₃, MAPbBr₃, and other inorganic nanocrystals without limitation.
the green photosensitive nanocrystal coating is produced by the following method: nanocrystals with organic ligand on a surface are ligand-exchanged with photosensitive ligand. Specifically, the photosensitive ligand is added to a nanocrystals solution with organic ligand on the surface, and the resulting mixture is vigorously stirred or shaken to produce a precipitate, which is the product.

Preferably, the nanocrystal solution with organic ligand on the surface is mixed with the photosensitive ligand in a mass ratio of 10:1, and the resulting mixture is vigorously stirred or shaken until a precipitate is generated as the product. Preferably, the concentration of the photosensitive ligand is greater than or equal to 50 mg/mL.

Preferably, the ligand exchange is done in an inert atmosphere.

A green photosensitive nanocrystal ink is prepared by dispersing the green photosensitive nanocrystal coating in a green solvent, the green solvent being propylene glycol methyl ether acetate (PGMEA), ethylene glycol methyl ether acetate (EGMEA), diethylene glycol monoethyl ether acetate(DGMEA), or propylene glycol methyl ether (PGME), octane.

Preferably, the green photosensitive nanocrystal coating is dispersed in a green solvent to form a stable colloidal solution, and the concentration of the green photosensitive nanocrystal coating is 10 to 25 mg/mL.

A method for a photoresist-free optical patterning method for colloidal nanocrystals in a green solvent comprises the steps of preparing a continuous dense nanocrystalline film of controllable thickness on a substrate using the green photosensitive nanocrystal ink; pressing a mask engraved with a specific pattern onto the film, exposing it to an ultraviolet light source, and developing the film in a developing solution.

Preferably, the substrate is a silicon, quartz or glass wafer.

Preferably, the developing solution is propylene glycol methyl ether acetate (PGMEA), ethylene glycol methyl ether acetate (EGMEA), diethylene glycol monoethyl ether acetate(DGMEA), or propylene glycol methyl ether (PGME), octane.

Compared with the prior art, the invention has the following advantages:
Photosensitive nanocrystals obtained through ligand exchange can be effectively dispersed in the green solvent to absorb an emission spectrum emitted by the green solvent, thereby preserving about 90% of photoluminescence quantum yield (PLQY) while keeping the morphology and size unchanged. Through the investigation of the mechanism, it is clear that the process is due to the free radical polymerization of acryloyl in a structure of photosensitive ligand under UV light, which shortens the distance between the nanocrystals, thus greatly reducing their solubility in solvents such as methylbenzene and propylene glycol methyl ether acetate.

The scheme solves the problem that nanocrystals cannot be subject to direct photolithography in the green solvent, and is expected to be applied to the commercialization of nanocrystals in the field of electroluminescent and photoluminescent quantum dot displays.

### 4. Brief Description of Accompany Drawings

FIG. 1a shows a first photoresist-based optical etching technique; FIG. 1b shows a second photoresist-based optical etching technique; FIG. 1c shows a photoresist-free photolithography technique; FIG. 1d shows the optical patterning method of the present invention, which is non-destructive to fluorescent properties;
FIG. 2 shows introduction of the photoacid generator (PAG) or bifunctional surface ligand in the colloidal nanocrystal system to enable photoresist-free lithography.
FIG. 3 is a schematic diagram of the method of nanocrystal surface treatment in the present invention.
FIG. 4 is a schematic diagram of the photolithography process of the present invention.
FIG. 5 is a comparative transmission electron microscope images of nanocrystals before (left) and after (right) ligand exchange.
FIG. 6 is a comparison of luminescence properties of the nanocrystals before (black line) and after (gray line) photosensitive ligand treatment.
FIG. 7 is a photolithographic pattern of 2-(3-mercaptopropionyloxy)ethyl methacrylate as a ligand.
FIG. 8 is a photolithographic pattern of 5-[3-methoxy-4-(2-(2-methylprop-2-enoyloxy) phenyl]valeral-4-olefine acid as a ligand.
FIG. 9 is a photolithographic pattern of 2-(6-(2-(methacryloyloxy) ethoxy)-2-oxo-2H-chromen-3-yl) acetic acid as a ligand.

### 5. Specific Embodiment of the invention

### Embodiment 1:

Direct photolithography of nanocrystals (quantum dots) in a green solvent with deep UV light and 2-(3-mercaptopropionyloxy)ethyl methacrylate as a ligand.

All ligand exchanges were done in a nitrogen-filled glove box (O₂ and H₂O < 0.01 ppm) with anhydrous solvent. The photosensitive ligand is 2-(3-mercaptopropionyloxy)ethyl methacrylate.

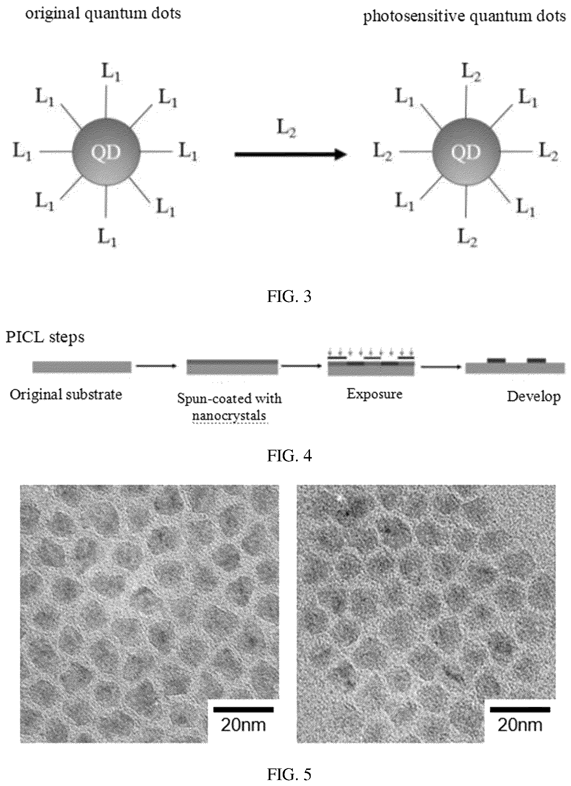

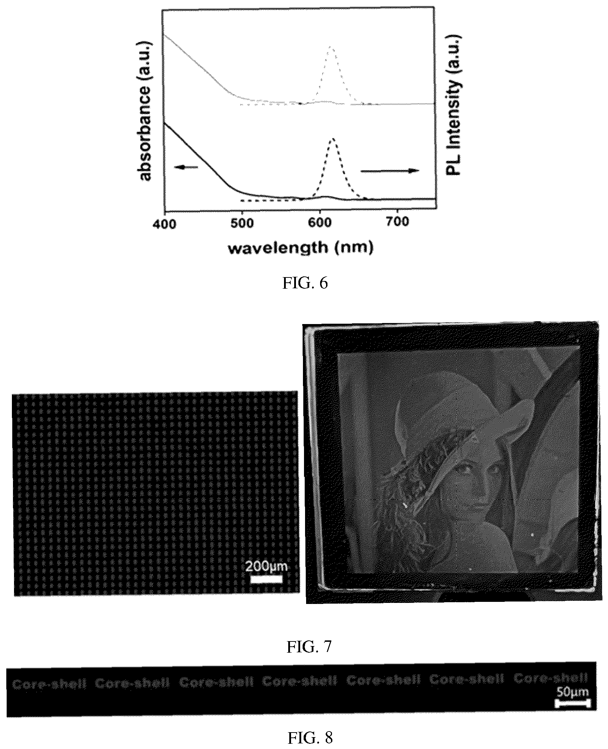

Red fluorescent nanocrystalline CdSe/ZnS quantum dots with oleic acid on surface were dispersed in n-hexane, and 2-(3-mercaptopropionyloxy)ethyl methacrylate was used as a pure material. Firstly, ligand exchange treatment was first performed with 200 µL of NCs solution (25 mg/mL) being added with 20 µL of 2-(3-mercaptopropionyloxy)ethyl methacrylate, and the resulting mixture was vigorously stirred or shaken until precipitation of NCs was observed. After centrifugation, the precipitate was re-dispersed in 200 µL of PGMEA and 1 mL of n-hexane was used to precipitate off the excess 2-(3-mercaptopropionyloxy)ethyl methacrylate ligand, and then centrifuged and dispersed again in PGMEA to form a stable colloidal solution (10-25 mg/mL) as shown in the TEM photograph of FIG. 5. 10 µL PGMEA solution of NCs was dropped on a surface of the silicon wafer, and spun-coated to form an even thin film in a spin coater. A mask with a specific pattern was pressed onto the film, exposed to a 254 nm UV light source, and developed in a PGMEA developing solution. The resulting pattern is shown in FIG. 7.

### Embodiment 2:

Direct photolithography of nanocrystals (quantum dots) in a green solvent with 365nm as a source light and 5-[3-methoxy-4-(2-(2-methylprop-2-enoyloxy) phenyl]valeral-4-olefine acid as a ligand.

All ligand exchanges were done in a nitrogen-filled glove box (O₂ and H₂O < 0.01 ppm) with anhydrous solvent. The photosensitive ligand is 5-[3-methoxy-4-(2-(2-methylprop-2-enoyloxy) phenyl]valeral-4-olefine acid.

Green fluorescent nanocrystalline CdSe/CdZnSeS quantum dots with oleic acid on surface were dispersed in n-hexane, and 5-[3-methoxy-4-(2-(2-methylprop-2-enoyloxy) phenyl]valeral-4-olefine acid is prepared into a solution in n-hexane. Firstly, ligand exchange treatment was first performed with 200 µL of NCs solution (25 mg/mL) being added with 20 µL of an n-hexane solution of 5-[3-methoxy-4-(2-(2-methylprop-2-enoyloxy) phenyl]valeral-4-olefine acid, and the resulting mixture was vigorously stirred or shaken until precipitation of NCs was observed. After centrifugation, the precipitate was re-dispersed in 200 µL of PGMEA and 1 mL of n-hexane was used to precipitate off the excess 5-[3-methoxy-4-(2-(2-methylprop-2-enoyloxy) phenyl]valeral-4-olefine acid ligand, and then centrifuged and dispersed again in PGMEA to form a stable colloidal solution (10-25 mg/mL), comparison of absorption and fluorescence spectra before and after treatment is shown in FIG. 6. 10 µL of PGMEA solution of NCs was dropped on a surface of the silicon wafer, and spun-coated to form an even thin film in a spin coater. A mask with a specific pattern was pressed onto the film, exposed to a 365 nm UV light source, and developed in a PGMEA developing solution. The resulting pattern is shown in FIG. 8. To fully demonstrate the generalizability of the method, we photolithography the red fluorescent quantum dots CdSeS/ZnS and blue fluorescent quantum dots CdZnS/ZnS, and both of them yielded nanocrystal patterns with preserved fluorescence.

### Embodiment 3:

Direct photolithography of nanocrystals (quantum dots) in a green solvent with 405nm as a source light and 2-(6-(2-(methacryloyloxy) ethoxy)-2-oxo-2H- chromen-3-yl) acetic acid as a ligand.

All ligand exchanges were done in a nitrogen-filled glove box (O₂ and H₂O < 0.01 ppm) with anhydrous solvent. The photosensitive ligand is 2-(6-(2-(methacryloyloxy) ethoxy)-2-oxo-2H- chromen-3-yl) acetic acid.

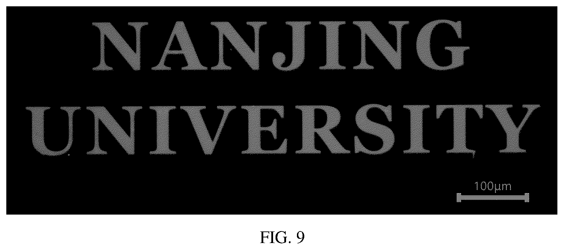

Green fluorescent nanocrystalline CdSe/CdZnSeS quantum dots with oleic acid on surface were dispersed in n-hexane, and 2-(6-(2-(methacryloyloxy) ethoxy)-2-oxo-2H-chromen-3-yl) acetic acid is prepared into a solution in n-hexane. Firstly, ligand exchange treatment was first performed with 200 µL of NCs solution (25 mg/mL) being added with 20 µL of an n-hexane solution of 2-(6-(2-(methacryloyloxy) ethoxy)-2-oxo-2H- chromen-3-yl) acetic acid, and the resulting mixture was vigorously stirred or shaken until precipitation of NCs was observed. After centrifugation, the precipitate was re-dispersed in 200 µL of PGMEA and 1 mL of n-hexane was used to precipitate off the excess 2-(6-(2-(methacryloyloxy) ethoxy)-2-oxo-2H- chromen-3-yl) acetic acid ligand, and then centrifuged and dispersed again in PGMEA to form a stable colloidal solution (10-25 mg/mL). 10 µL of PGMEA solution of NCs was dropped on a surface of the silicon wafer, and spun-coated to form an even thin film in a spin coater. A mask with a specific pattern was pressed onto the film, exposed to a 365 nm UV light source, and developed in a PGMEA developing solution. The resulting pattern is shown in FIG. 9.

### Embodiment 4:

The same experimental method as in Embodiment 3 was used and adopts the following photosensitive ligands instead of 2-(6-(2-(methacryloyloxy) ethoxy)-2-oxo-2H- chromen-3-yl) acetic acid can also achieve the same technical effect.
(2E)-3-(3-methoxy-4-{2-[(2-methylprop-2-enoyl)oxygroup]ethoxy}phenyl)prop-2-olefine acid,
4-(4-(methacryloyloxy)phenoxy)-4-oxobutanoic acid,
mono-2-(methacryloyloxy) ethylsuccinate,
(E)-6-(4-(methacryloyloxy)phenyl)-4-oxohex-5-olefine acid,
(E)-6-(4-(methacryloyloxy)-3-methoxyphenyl)-4-oxohex-5-olefine acid,
(E)-6-(4-(methacryloyloxy)-3, 5-dimethoxyphenyl)-4-oxohex-5-olefine acid, phenyl-[4-(10-mercaptodecyloxy) phenyl] methanone, phenyl-[4-(10-mercaptodecylthio) phenyl]methanone,
4-pyrrolidinyl-phenyl-[4-(10- mercaptodecylthio)phenyl]methanone.

### Embodiment 5:

The same experimental method as in Embodiment 3 was used and CdS, CdSe, CdSe/ZnS, CdSeS/ZnS, CdSe/CdZnSeS/ZnS, CdZnS/ZnS, CdZnSe/ZnS, ZnSe/ZnS, CdSe/CdS, CdSeS/CdS, InP , InP/ZnS, InP/ZnSe/ZnS, InGaP/ZnSe/ZnS, CdTe, PbS, PbSe, PbS/CdS, Fe₂O₃, Fe₃O₄, TiO₂, ITO, In₂O₃, CsPbBr₃, MAPbBr₃ nanocrystals are adopted respectively to replace CdSe/CdZnSeS quantum dots and can also achieve the same technical effect.

### Embodiment 6:

The same experimental method as in Embodiment 3 was used and adopts octane, ethylene glycol methyl ether acetate (EGMEA), diethylene glycol monoethyl ether acetate(DGMEA), or propylene glycol methyl ether (PGME) to replace propylene glycol methyl ether acetate (PGMEA) and can also achieve the same technical effect.

It should be noted that the above embodiment is only a better embodiment of the present invention, and is not intended to limit the scope of protection of the present invention, and any equivalent replacement or substitution made on the basis of the above belongs to the scope of protection of the present invention.

## Claims

1. A green photosensitive nanocrystal coating, comprising nanocrystals and photosensitive ligands; the photosensitive ligands contain groups that coordinates with the nanocrystals, and methylacryloyl or benzophenone photosensitive group.

2. The green photosensitive nanocrystal coating of claim 1, wherein groups that coordinates with the nanocrystals is any one or more of carboxylate radical or amino or mercapto group.

3. The green photosensitive nanocrystal coating of claim 1, wherein the photosensitizing ligand is any one of 2-(3-mercaptopropionyloxy)ethyl methacrylate, 5-[3-methoxy-4-(2-(2-methylprop-2-enoyloxy)phenyl]valeral-4-olefine acid, (2E)-3-(3-methoxy-4-{2-[(2-methylprop-2-enoyl)oxygroup]ethoxy}phenyl)prop-2-olefine acid, 4-(4-(methacryloyloxy)phenoxy)-4-oxobutanoic acid, mono-2-(methacryloyloxy) ethylsuccinate, (E)-6-(4-(methacryloyloxy)phenyl)-4-oxohex-5-olefine acid, (E)-6-(4-(methacryloyloxy)-3-methoxyphenyl)-4-oxohex-5-olefine acid, (E)-6-(4- (methacryloyloxy)-3, 5-dimethoxyphenyl)-4-oxohex-5-olefine acid, 2-(6-(2-(methacryloyloxy)ethoxy)-2-oxo-2H-chromen-3-yl) acetic acid, phenyl-[4-(10-mercaptodecyloxy) phenyl] methanone, phenyl-[4- (10-mercaptodecylthio)phenyl] methanone, and 4-pyrrolidinyl-phenyl-[4-(10- mercaptodecylthio)phenyl]methanone.

4. The green photosensitive nanocrystal coating of claim 1, wherein the nanocrystal is any one of CdS, CdSe, CdSe/ZnS, CdSeS/ZnS, CdSe/CdZnSeS/ZnS, CdZnS/ZnS, CdZnSe/ZnS, ZnSe/ZnS, CdSe/CdS, CdSeS/CdS, InP , InP/ZnS, InP/ZnSe/ZnS, InGaP/ZnSe/ZnS, CdTe, PbS, PbSe, PbS/CdS, Fe₂O₃, Fe₃O₄, TiO₂, ITO, In₂O₃, CsPbBr₃, MAPbBr₃, and the nanocrystals comprise a primary organic ligand, and the primary organic ligand is any one or a combination of carboxylic acids, phosphonic acids, amines with an aliphatic chain of more than 8 carbons.

5. A preparation method for the green photosensitive nanocrystal coating of any claim from claim 1 to 4, comprising the following steps: the photosensitive ligand is added to a nanocrystals solution with organic ligand on the surface, and the resulting mixture is vigorously stirred or shaken to produce a precipitate, which is the product.

6. The preparation method of claim 5, wherein in an inert atmosphere, 25 mg/mL of nanocrystal solution with organic ligand on the surface is mixed with the photosensitive ligand in a mass ratio of 10:1, and the resulting mixture is vigorously stirred or shaken until a precipitate is generated as the product. Preferably, the concentration of the photosensitive ligand is greater than or equal to 50 mg/mL.

7. A preparation method for a green photosensitive nanocrystal ink, wherein dispersing the green photosensitive nanocrystal coating in a green solvent of any claim from claim 1 to 4, the green solvent being propylene glycol methyl ether acetate, ethylene glycol methyl ether acetate, octane, diethylene glycol monoethyl ether acetate, or propylene glycol methyl ether.

8. The preparation method of claim 7, wherein the green photosensitive nanocrystal coating is dispersed in a green solvent to form a stable colloidal solution, and the concentration of the green photosensitive nanocrystal coating is 10 to 25 mg/mL.

9. A method for a photoresist-free optical patterning method for colloidal nanocrystals in a green solvent, comprising the following steps: preparing a continuous dense nanocrystalline film of controllable thickness on a substrate using the green photosensitive nanocrystal ink of claim 7; pressing a mask engraved with a specific pattern onto the film, exposing it to an ultraviolet light source, and developing the film in a developing solution.

10. The method of claim 9, wherein the substrate is a silicon, quartz or glass wafer; and the developing solution is propylene glycol methyl ether acetate, ethylene glycol methyl ether acetate, octane, diethylene glycol monoethyl ether acetate, or propylene glycol methyl ether.
